# EUROPÄISCHE PATENTSCHRIFT

(11) **EP 3 086 132 B1**
(45) Veröffentlichungstag und Bekanntmachung des Hinweises auf die Patenterteilung: **02.05.2018**
(21) Anmeldenummer: 16162792.2
(22) Anmeldetag: 30.03.2016
(51) Int. Cl.: G01R 31/04

(54) **ELEKTRONISCHES BAUELEMENT MIT MEHREREN KONTAKTSTRUKTUREN UND VERFAHREN ZUR ÜBERWACHUNG VON KONTAKTSTRUKTUREN EINES ELEKTRONISCHEN BAUELEMENTS**
ELECTRONIC COMPONENT COMPRISING A PLURALITY OF CONTACT STRUCTURES AND METHOD FOR MONITORING CONTACT STRUCTURES OF AN ELECTRONIC COMPONENT
COMPOSANT ELECTRONIQUE COMPRENANT PLUSIEURS STRUCTURES DE CONTACT ET PROCEDE DE SURVEILLANCE DE STRUCTURES DE CONTACT D'UN COMPOSANT ELECTRONIQUE

(30) Priorität: 01.04.2015 EP 15162264; 12.06.2015 DE 102015210851
(43) Veröffentlichungstag der Anmeldung: 26.10.2016
(73) Patentinhaber: Siemens Aktiengesellschaft, 80333 München (DE); Fraunhofer-Gesellschaft zur Förderung der angewandten Forschung e.V., 80686 München (DE); Robert Bosch GmbH, 70839 Gerlingen-Schillerhöhe (DE)
(72) Erfinder: Frühauf, Peter, 14612 Falkensee (DE); Gromala, Przemyslaw, 72760 Reutlingen (DE); Rzepka, Sven, 01187 Dresden (DE); Wilke, Klaus, 12527 Berlin (DE)

(56) Entgegenhaltungen:
- US-A1- 2007 252 612
- US-A1- 2009 058 435
- US-A1- 2010 070 204
- US-A1- 2011 095 776
- US-A1- 2012 001 642
- US-A1- 2012 217 976

## Beschreibung

Die Erfindung betrifft ein elektronisches Bauelement, welches zur Integration in der eingangs beschriebenen Baugruppe geeignet ist. Daher verfügt das Bauelement über einen auf einem regelmäßigen (insbesondere rechteckigen oder quadratischen) Raster oder über in gleichmäßigen Abständen angeordnete Kontaktflächen für Kontaktstrukturen zur Kontaktierung auf einem Substrat. Dabei sind elektrische Verbindungen zwischen einer mit dem Bauelement realisierten elektronischen Nutzschaltung und den Kontaktflächen ausgebildet.

Außerdem betrifft die Erfindung ein Verfahren zur Überwachung einer aus Kontaktstrukturen bestehenden elektrischen Kontaktierung eines elektronischen Bauelements mit einem Substrat. Mit anderen Worten ist das elektronische Bauelement auf dem Substrat montiert und wird dort zumindest durch die elektrische Kontaktierung fixiert. Zusätzlich zu den Kontaktstrukturen zwischen dem Bauelement und dem Substrat ist mindestens eine Teststruktur ausgebildet, die den oben beschriebenen Zweck erfüllt. Mit einer Messeinrichtung wird eine mit der Teststruktur verknüpfte elektrische Größe gemessen. Dies bedeutet, dass mittels der Messeinrichtung die elektrischen Eigenschaften bezüglich dieser elektrischen Größe überwacht werden können. Hierbei kann es sich beispielsweise um den elektrischen Widerstand der Teststruktur handeln. Die elektrische Größe wird mit einer Auswertungseinheit hinsichtlich einer Funktionszuverlässigkeit der elektrischen Kontaktierung ausgewertet. Die Messeinrichtung und die Auswertungseinheit ergeben damit gemeinsam die oben bereits angegebene Überwachungsschaltung.

Nach Montage des Bauelements entsteht eine elektronische Baugruppe mit einem Substrat, auf dem ein Bauelement über mehrere Kontaktstrukturen elektrisch leitfähig kontaktiert ist. Dabei bilden diese Kontaktstrukturen elektrische Verbindungen zwischen einer mit dem Bauelement realisierten elektronischen Nutzschaltung und Kontakten auf dem Substrat aus. Als elektronische Nutzschaltung im Zusammenhang mit dieser Erfindung soll eine durch das Bauelement realisierte Schaltung verstanden werden, welche die Funktion des Bauelements in der elektronischen Baugruppe definiert. Hierbei handelt es sich um eine Schaltung, die in die den Zweck der elektronischen Baugruppe bestimmenden Gesamtschaltung integriert ist.

Außerdem verfügt das Bauelement über auf einem regelmäßigen Raster oder über in gleichmäßigen Abständen angeordnete Kontaktflächen zur Kontaktierung der Kontaktstrukturen. Ein regelmäßiges Raster im Sinne der Erfindung besteht aus Rasterzellen konstanter Geometrie. Die Rasterzellen liegen einander benachbart und ergeben in ihrer Gesamtheit das Raster. Regelmäßige Raster können beispielsweise kartesisch ausgerichtet sein, d. h., dass die Rasterzellen rechteckig oder quadratisch ausgeführt sein können. Die Kontaktflächen sind dann auf den jeweiligen Eckpunkten der Rasterzellen vorgesehen, wobei ein solches Raster die Form eines Gitters aufweist.

Auch ist es möglich, die Kontaktflächen in gleichmäßigen, d. h. jeweils denselben Abständen zueinander anzuordnen. Auch hierdurch wird eine Regelmäßigkeit bei der Anordnung der Kontaktflächen erzielt. Insbesondere können die Kontaktflächen in einer Reihe angeordnet werden, wobei die Kontaktflächen innerhalb dieser Reihe untereinander gleichmäßige Abstände aufweisen.

Wenn die Kontaktflächen in einem regelmäßigen Raster angeordnet sind, so bedeutet dies nicht, dass alle Rasterplätze von Kontaktflächen belegt sein müssen. Es ist auch möglich, dass zwar alle Kontaktflächen auf einem der durch das Raster definierten Punkte liegen, allerdings bestimmte Rasterpunkte nicht durch Kontaktflächen belegt sind.

Weiterhin ist mindestens eine Teststruktur zur Feststellung eines drohenden Versagens der Kontaktstrukturen mit dem Bauelement und mit dem Substrat elektrisch leitfähig kontaktiert. Dabei unterscheidet sich die Teststruktur von den Kontaktstrukturen dadurch, dass diese nicht in der Art mit der elektronischen Nutzschaltung kontaktiert ist, dass deren Funktion bei einem Versagen der Teststruktur ausfallen würde. Denn das würde bedeuten, dass ein Ausfallen der Teststruktur ein Versagen der Nutzfunktion der elektronischen Baugruppe zur Folge haben würde. Vielmehr kann die Teststruktur so in eine elektronische Schaltung integriert werden, dass das Versagen der Teststruktur im Rahmen der ordnungsgemäßen Funktion der elektronischen Baugruppe erkannt werden kann, um ein drohendes Versagen der elektronischen Baugruppe selbst zu ermitteln.

Eine elektrische Baugruppe, ein elektrisches Bauelement und ein Verfahren zur Überwachung von Kontaktstrukturen, wie eingangs angegeben, ist beispielsweise aus der US 2010/0070204 A1 bekannt. Gemäß diesem Dokument werden Teststrukturen aufgebaut, die beispielsweise aus Lotkugeln bestehen können, welche auf der Unterseite eines Ball Grid Arrays (im Folgenden BGA) angebracht werden. Auf dem BGA sind überdies in einem Raster Lotkugeln zur Kontaktierung der Kontaktflächen einer durch den BGA realisierten Nutzschaltung vorgesehen. Es wird vorgeschlagen, die Lotkontakte der Nutzschaltung, die auf einem regelmäßigen Raster liegen, so zu verteilen, dass in den höchst belasteten Bereichen des BGAs, die in den Ecken liegen, keine Kontaktflächen vorgesehen werden. Diese deswegen frei bleibende Fläche wird zur Unterbringung von Teststrukturen genutzt, die ebenfalls aus Lotkontakten bestehen und hinsichtlich ihres Versagens so überwacht werden können, dass unter Hinzuziehung einer Datenbank mit Erfahrungswerten für das Bauteilversagen eine Vorhersage für eine Restlebensdauer der elektronischen Baugruppe getroffen werden kann. Dabei werden die Teststrukturen bewusst geschwächt, indem beispielsweise ein kleineres Volumen der Teststrukturen im Vergleich zu den Kontaktstrukturen vorgesehen wird. In den vier Ecken des BGAs können Teststrukturen mit unterschiedlichen Eigenschaften (beispielsweise unterschiedlichem Volumen oder unterschiedlichen Abständen zueinander) angeordnet werden, um auf diesem Wege unterschiedlich schnell versagende Teststrukturen zu erzeugen.

Durch das zusätzliche Vorsehen von Teststrukturen und das gleichzeitige Weglassen von Kontaktstrukturen, um Platz für die Teststrukturen zu schaffen, werden die mechanischen und thermischen Eigenschaften der elektronischen Baugruppe verglichen mit einer Baugruppe ohne solche Teststrukturen verändert. Daher ist es erforderlich, für die modifizierte Baugruppe neue Erfahrungswerte hinsichtlich der Lebensdauer der elektronischen Verbindungen zu erstellen, um diese in die Datenbank einzuspeisen. Auf diesem Wege kann die erforderliche Zuverlässigkeit der Lebensdauervorhersage gemäß dem in der US 2010/0070204 A1 Verfahren erfüllt werden.

Alternativ werden im Stand der Technik auch andere Überwachungsverfahren vorgeschlagen. Gemäß der DE 10 2005 033 899 A1 kann eine Abtastung von elektrischen Verbindungsstellen ohne mechanische Einwirkung, also berührungslos mittels Ultraschall oder mittels elektromagnetischer Strahlung durchgeführt werden. Hierbei werden bestimmte Veränderungen der untersuchten Eigenschaften in geeigneter Weise ausgewertet, um Aussagen über die Qualität der untersuchten elektrischen Schaltung zu gewinnen. Alterungsbedingte Prozesse an Lötverbindungen können dadurch erfasst werden, dass diese Verbindungsbereiche zu verschiedenen Zeitpunkten in einer nach dem beschriebenen Prinzip funktionierenden Prüfeinrichtung geprüft und miteinander verglichen werden. Hierzu ist jedoch eine Unterbrechung des Betriebs der elektronischen Baugruppe erforderlich, da diese in die Prüfeinrichtung eingesetzt werden muss.

Gemäß der DE 10 2011 076 094 A1 wird erwähnt, dass man eine Lötverbindung, die bei einem Halbleiterchip zum Zwecke der Kühlung vorgesehen wird, aus mehreren Kontaktflächen aufbauen kann, so dass man diese Kontaktflächen auf unterschiedliche Spannungspotentiale legen kann. Hierdurch lassen sich die elektrischen Eigenschaften der Lötverbindungen messen, wobei sich durch die Analyse des Messergebnisses auf die Qualität der Lötverbindung schließen lässt. Dieses Verfahren ermöglicht es, aufwendige Röntgenuntersuchungen einzusparen. Bei diesem Verfahren wird allerdings diejenige Lötverbindung, deren Qualität es zu überwachen gilt, auch als Teststruktur genutzt.

Gemäß der US 7,478,741 B1 ist es bekannt, dass Teststrukturen beispielsweise in einem Ball Grid Array auch auf Kontaktflächen ausgebildet werden können, die für den bestimmungsgemäßen Gebrauch des Ball Grid Arrays nicht erforderlich sind. Diese können beispielsweise in den Ecken des Ball Grid Arrays liegen und aus einem Lotmaterial gebildet werden, welches einen geringeren Widerstand gegen Versagen aufweist. Auch können diese speziellen Teststrukturen mechanisch geschwächt werden, indem diese beispielsweise mit einem geringeren Volumen hergestellt werden. Die Teststrukturen werden auch mit einem Substrat kontaktiert, wobei auf diesem Substrat auch eine Überwachungseinrichtung vorgesehen ist, die einen Ausfall der Teststrukturen anzeigt.

Gemäß der US 2012/001642 A1, der US 2012/217976 A1, der US 2011/095776 A1, der US 2007/252612 A1 und der US 2009/058435 A1 sind elektronische Baugruppen beschrieben, die mit Teststrukturen zum Detektieren eines Versagens ausgestattet sind. Diese Teststrukturen befinden sich beispielsweise bei einem Ball Grid Array auf Kontaktflächen, die dieser in einer matrixförmigen Anordnung zur Verfügung stellt. Vorzugsweise sind die Teststrukturen auf den Kontaktflächen vorgesehen, die sich in den Ecken des Ball Grid Arrays befinden, da diese einer erhöhten mechanischen Beanspruchung ausgesetzt sind. Hierdurch ist gewährleistet, dass die Teststrukturen, die durch Lotkontakte ausgebildet sind, vor den Lotkontakten versagen, die für die Funktion des Bauelements erforderlich sind. Dadurch kann das drohende Versagen des Bauelements durch eine Überwachung der Teststrukturen auf ein Versagen hin vorausgesagt werden. Eine Reparatur ist dann vor dem Eintreffen des Schadensfalls bereits möglich.

Die Aufgabe der Erfindung besteht darin, ein Bauelement mit Kontaktstrukturen zur Kontaktierung auf einem Substrat bzw. ein Verfahren zur Überwachung von Kontaktstrukturen zwischen einem Bauelement und einem Substrat anzugeben, mit der bzw. mit dem die Überwachung der Kontaktstrukturen zuverlässig und mit vergleichsweise geringem technischen Aufwand ermöglicht wird.

Die Aufgabe wird durch das eingangs angegebene elektronische Bauelement dadurch gelöst, dass eine der Kontaktflächen elektrisch unabhängig von der elektronischen Nutzschaltung ist und mit einer anderen von der elektronischen Nutzschaltung elektrisch unabhängigen Kontaktfläche oder mit einem Masseanschluss elektrisch verbunden ist. Mit anderen Worten ist das elektronische Bauelement dafür vorbereitet, dass Kontaktflächen zur Verfügung stehen, welche mit Teststrukturen im Sinne dieser Erfindung versehen werden können. Hierzu ist es erforderlich, dass diese Kontaktflächen unabhängig von der Funktion der elektronischen Nutzschaltung ausgeführt sind, so dass sie für Teststrukturen zur Verfügung stehen. Wenn diese Teststrukturen im späteren Betrieb ausfallen, wird daher erfindungsgemäß die elektronische Nutzschaltung hiervon nicht betroffen. Die hiermit verbundenen Vorteile sind obenstehend bereits erläutert worden.

Wenn die eine Kontaktfläche mit einer weiteren Kontaktfläche elektrisch verbunden ist, so lässt sich mit diesen beiden von der Nutzschaltung elektrisch unabhängigen Kontaktflächen ein Stromkreis erzeugen, der durch die Teststruktur verläuft. Dieser Stromkreis kann für elektrische Messungen verwendet werden, wobei die elektrische Messgröße hinsichtlich eines Versagens der Teststruktur ausgewertet werden kann. Dabei können an beiden Kontaktflächen Teststrukturen vorgesehen werden, die an zwei Orten mit hoher mechanischer Beanspruchung des Bauelements gelegen sind.

Eine andere Möglichkeit besteht darin, die unabhängige Kontaktfläche für die Teststruktur mit einem Masseanschluss elektrisch zu verbinden. Hiermit ist ein Anschluss gemeint, der auf einem bekannten Potential liegt, so dass die an der Teststruktur gemessene elektrische Größe zuverlässig ausgewertet werden kann.

Erfindungsgemäß ist vorgesehen, dass die Teststruktur im Vergleich zu den Kontaktstrukturen eine geringere Haltbarkeit gegenüber den im Betrieb der Baugruppe auftretenden Belastungen aufweist. Als Haltbarkeit im Sinne der Erfindung wird der Widerstand der Kontaktstrukturen gegen ein Versagen verstanden. Hierbei ist zu berücksichtigen, dass die Kontaktstrukturen dem Zweck einer Leitung des elektrischen Stroms zwischen der Kontaktfläche des Bauelements und dem Kontakt des Substrats dienen sollen. Diese Funktion kann auch bei einer beginnenden Schädigung der Kontaktstrukturen noch gewährleistet werden. Wichtig ist es, dass die Teststruktur mit genügender Sicherheit vor den Kontaktstrukturen versagt oder zumindest aufgrund einer Änderung ihrer elektrischen Eigenschaften ein baldiges Versagen anzeigt. Dies kann erfindungsgemäß als Kriterium herangezogen werden, um ein Auswechseln oder Reparieren der Baugruppe oder des Bauelements vor einem elektrischen Versagen der Nutzschaltung zu initiieren, wodurch ein Ausfallen der Baugruppe verhindert werden kann. Dies ist insbesondere für elektronische Baugruppen zwingend, deren Funktion für sicherheitsrelevante Anwendungen benötigt wird. Als Beispiele hierfür können beispielsweise die Lenkung und Bremse von Kraftfahrzeugen oder auch Anwendungen in Luftfahrzeugen genannt werden. Eine zuverlässige Aussage eines Versagens solcher sicherheitsrelevanten elektronischen Baugruppen macht es überflüssig, redundante Baugruppen vorzusehen, die im Falle des Versagens der Baugruppe ersatzweise die Funktion übernehmen können.

Wird für die Teststruktur eine geringere Haltbarkeit vorgesehen als für die Kontaktstrukturen, so kann vorteilhaft das Versagen der Teststruktur unabhängig von ihrer Platzierung in einem stark beanspruchten Bereich des Bauelements beeinflusst werden. Hierdurch lässt sich beispielsweise die Sicherheitsreserve für die Kontaktstrukturen nach einem Versagen der Teststruktur vergrößern, indem die Teststruktur gezielt geschwächt wird. Als Beispiele können z. B. für Lötverbindungen Lotlegierungen verwendet werden, die gegenüber einer Rissbildung anfälliger sind als das Material der Kontaktstrukturen. Auch ist es möglich, beispielsweise bei Wire Bonds Sollbruchstellen vorzusehen. Eine weitere Möglichkeit besteht darin, die Kontaktstruktur mit einem geringeren Volumen zu fertigen. Bei Vias können beispielsweise dünnere Schichtdicken für die Metallisierung vorgesehen werden. Auch hier ist es möglich, eine andere Metalllegierung für die Metallisierung zu verwenden. Eine weitere Möglichkeit besteht darin, die Teststruktur durch eine Nachbehandlung zu verspröden. Diese Nachbehandlung kann beispielsweise durch eine Kaltverfestigung erfolgen, indem die Teststruktur nach ihrer Herstellung verformt wird (was eine Zugänglichkeit dieser Teststruktur voraussetzt).

Erfindungsgemäß wird die Teststruktur an eine Überwachungsschaltung angeschlossen. Diese Überwachungsschaltung ermöglicht die Überwachung einer elektrischen Eigenschaft der Teststruktur, wobei die Überwachungsschaltung gleichzeitig an einem Ausgang die Notwendigkeit eines Austauschs des Bauelements oder einer Reparatur der Baugruppe oder eines Austauschs der ganzen Baugruppe anzeigen kann, um ein Versagen der Baugruppe zuverlässig zu verhindern. Die Überwachungsschaltung ist erfindungsgemäß in dem Bauelement verwirklicht sein. Ist die Überwachungsschaltung im Bauelement untergebracht, so handelt es sich bei dieser Funktion nicht um die Nutzfunktion des Bauelements, welche durch die Nutzschaltung realisiert ist. Allerdings können die Überwachungsschaltung und die Nutzschaltung physikalisch in einer Einheit verwirklicht sein. Wichtig ist allerdings, dass die Nutzschaltung auch bei Versagen der Teststruktur funktionsfähig bleibt. Vorteilhaft bleibt auch die Überwachungsschaltung funktionsfähig, um ein Signal generieren zu können, welches die Notwendigkeit eines Eingreifens anzeigt. Allerdings ist es auch möglich, dass die Überwachungsschaltung als solche durch ein Versagen der Teststruktur ausfällt. In diesem Fall muss der Ausfall der Überwachungsschaltung als Ereignis angezeigt werden, welches als notwendiger Handlungsbedarf für die Wartung Baugruppe interpretiert werden muss.

Gemäß einer Ausgestaltung der Erfindung kann die Überwachungsschaltung eine Schnittstelle zur Ausgabe eines Überwachungssignals aufweisen. Diese Schnittstelle kann das Überwachungssignal beispielsweise an eine Ausgabeeinrichtung weitergeben, welche die Notwendigkeit eines Austauschs oder einer Reparatur der Baugruppe anzeigt, um einen Ausfall aufgrund eines Versagens der Kontaktstrukturen zu verhindern. Diese Ausgabeeinheit kann beispielsweise das Bedienpaneel einer Maschine oder eines Kraftfahrzeugs sein.

Eine andere Möglichkeit besteht darin, dass das Überwachungssignal über die Schnittstelle an die Nutzschaltung des Bauelements weitergegeben wird. Dies ist von Vorteil, wenn in dem Bauelement Funktionen zur Selbstüberwachung integriert sind, mit deren Hilfe das Überwachungssignal ausgewertet werden kann. Im einfachsten Fall wird das Überwachungssignal mit einem geeigneten Eingang der Nutzschaltung (z.B. Interruptleitung, Analoger oder Digitaler Eingang) kontaktiert, so dass die Nutzschaltung darauf reagieren kann.

Nach Montage des Bauelements ist erfindungsgemäß vorgesehen, dass mindestens eine der auf einem regelmäßigen Raster oder in gleichmäßigen Abständen angeordneten Kontaktflächen von den Kontaktstrukturen frei bleibt und die Teststruktur auf dieser Kontaktfläche elektrisch leitfähig kontaktiert ist. Erfindungsgemäß ist damit vorgesehen, dass für die Kontaktierung der Teststruktur eine Kontaktfläche genutzt wird, die sich von dem für die Kontaktstrukturen genutzten Kontaktflächen nicht unterscheidet. Hierdurch kann das Verhalten der Teststruktur auf dieser Kontaktfläche ohne die Erhebung zusätzlicher Daten besser vorausgesagt werden, weswegen der Aufwand für das Auffinden eines geeigneten Überwachungsverfahrens verringert wird. Vorteilhaft kann dabei ausgenutzt werden, dass die Kontaktflächen des Bauelements im Betrieb der Baugruppe unterschiedlich stark belastet werden. Kontaktflächen, deren Kontaktierung mit Kontaktstrukturen erfahrungsgemäß zu elektrischen Verbindungen führen, die besonders beansprucht werden, können bewusst freigelassen werden, um dort erfindungsgemäß eine Teststruktur vorzusehen. Gemäß einer Ausgestaltung der Erfindung ist dann vorgesehen, dass die Teststruktur auf einer Kontaktfläche kontaktiert ist, die im Betrieb der Baugruppe höheren Belastungen ausgesetzt ist, als andere mit Kontaktstrukturen kontaktierte Kontaktflächen. Vorzugsweise kann auch die Kontaktfläche für die Teststruktur ausgewählt werden, die erfahrungsgemäß oder gemäß Tests oder Berechnungen höheren Belastungen ausgesetzt ist als alle anderen mit Kontaktstruktur kontaktierten Kontaktflächen.

Wenn die Teststruktur auf Kontaktflächen hergestellt werden kann, die innerhalb des regelmäßigen Rasters liegen oder auf einer der in gleichmäßigen Abständen angeordneten Kontaktflächen, hat dies den Vorteil, dass die für die Herstellung des Bauelements genutzten Herstellungsverfahren nur wenig oder gar nicht abgeändert werden müssen, da diese Kontaktflächen konstruktiv auch für die Unterbringung von Kontaktstrukturen genutzt werden könnten. Sind überdies die Teststrukturen in ihrer Geometrie und hinsichtlich des verwendeten Werkstoffs identisch mit den Kontaktstrukturen, so können diese auch vorteilhaft im selben Arbeitsgang mit den Kontaktstrukturen hergestellt werden, ohne dass eine Modifikation des Herstellungsverfahrens erforderlich ist. Hierdurch ist eine technisch besonders einfache Lösung zu erreichen. Überdies kann bei der Vorhersage der beanspruchungsbedingten Lebensdauerüberwachung der elektronischen Baugruppe auf Erfahrungswissen oder bestehende Ergebnisse aus der Serienproduktion zurückgegriffen werden, da die modifizierte Baugruppen sich mechanisch und thermisch genauso verhält, wie eine Baugruppe, bei der anstelle der Teststrukturen gleichartige Kontaktstrukturen ausgebildet wären. Damit sind zuverlässige Voraussagen für die Lebensdauer der Baugruppe ohne Messungen und Erstellung von Datenbanken möglich.

Die Kontaktflächen am Bauelement können durch unterschiedliche Strukturen ausgebildet sein, wie diese für in Surface Mounted Technology (im Folgenden SMT) montierte Bauelemente üblich sind. Die Kontaktflächen können beispielsweise als Kontaktpads ausgeführt sein; als Bauelemente können neben den bereits erwähnten BGAs auch Land Grid Arrays (im Folgenden LGA) oder Chip Scale Packages (im Folgenden CSP) verbaut werden.

LGAs dienen zum Beispiel zur Aufnahme eines flächenmäßig kleineren elektronischen Bauelements oder mehreren Bauelementen, beispielsweise Halbleiterbausteinen. Diese werden auf dem LGA vorzugsweise auf einer metallischen Fläche befestigt, wodurch eine Kühlung dieses Bauelements gewährleistet ist. Die Kontaktierung dieses kleineren Bausteins erfolgt dann über die Kontaktflächen, die auf dem LGA vorgesehen sind und typischerweise den kleineren Baustein umgeben. Die so entstandene Struktur soll als mit dem Substrat zu verbindendes Bauelement im Zusammenhang mit dieser Erfindung verstanden werden. Die Kontaktflächen können mit Lotdepots wie zum Beispiel Lotkugeln vorbelotet sein.

Bei CSPs handelt es sich um gehäuste Halbleiterbauelemente, deren Gehäuse nur geringfügig größer ausfällt als das Halbleiterbauelement. Die Kontaktflächen können direkt unter dem Halbleiterbauelement vorgesehen werden. Wird das Halbleiterbauelement ohne Gehäuse verwendet, handelt es sich um einen Flip-Chip, dessen Kontakte ebenfalls auf der Unterseite vorgesehen werden können. Die Kontakte werden vorzugsweise durch Lotkugeln realisiert, wie dies für BGAs schon beschrieben wurde.

Das Substrat stellt Kontakte zur Verfügung, mit denen die Kontaktflächen des Bauelements über die Kontaktstrukturen verbunden werden können. Typischerweise werden die Kontakte des Substrats durch Leiterbahnen oder Kontaktpads zur Verfügung gestellt. Das Substrat wird in einer geeigneten Weise strukturiert, um auf dessen Oberfläche oder in dessen Inneren die elektrischen Leitpfade zur Kontaktierung des Bauelements zur Verfügung zu stellen. Das Substrat kann beispielsweise durch eine Leiterplatte gebildet werden. Möglich ist es jedoch auch, dreidimensionale Substrate in Form beispielsweise von Gehäusebauteilen zu verwenden. Diese können gleichzeitig als Schaltungsträger dienen und somit Kontakte für die Aufnahme von Bauelementen zur Verfügung stellen. Solche Gehäusebauteile können beispielsweise als Moulded Interconnect Device (im Folgenden MID) hergestellt werden.

Als Kontaktstrukturen kommen neben Lötverbindungen, wie sie bei Flip-Chips, CSPs, LGAs und BGAs zum Einsatz kommen, auch andere Strukturen in Betracht, bei denen mechanische und thermische Beanspruchungen der Baugruppe zu einem Versagen der elektrischen Kontakte führen können. So können beispielsweise bei der Kontaktierung von Chips auch Wire Bonds Verwendung finden, wobei diese Wire Bonds Kontaktflächen auf der Oberseite des Chips mit dem Substrat verbinden. Weiterhin kann eine Kontaktierung durch Substrate und Bauelemente hindurch durch sogenannte Vias erfolgen. Hierbei handelt es sich um Durchgangslöcher in der betreffenden Struktur, die an den Wänden metallisiert werden, um eine elektrische Verbindung durch diese Struktur hindurch zu ermöglichen. Unterschieden wird je nach Struktur unter Through Silicon Vias (im Folgenden TSV), Through Encapsulent Vias (im Folgenden TEV), Through Mold Vias (im Folgenden TMV) und Plated Through Holes (im Folgenden PTH). Auch bei den genannten alternativen Kontaktstrukturen ist es möglich, die zugehörigen Teststrukturen diesen Kontaktstrukturen nachzuempfinden, so dass deren mechanisches und thermisches Verhalten mit den Kontaktstrukturen vergleichbar und damit gut vorhersagbar ist. Insbesondere kann vorteilhaft diejenige Stelle des Bauelements ausgewählt werden, die den höchsten mechanischen und/oder thermischen Belastungen ausgesetzt ist, um das Versagen einer Teststruktur als zuverlässiges Anzeichen des baldigen Versagens von Kontaktstrukturen interpretieren zu können.

Wenn das Bauelement ein BGA oder ein LGA ist, kann vorteilhaft vorgesehen werden, dass die Teststruktur auf einer Kontaktfläche vorgesehen ist, die einer Ecke des BGA oder LGA oder der Ecke eines in den BGA eingebetteten oder in den LGA aufgesetzten Halbleiterbausteins am nächsten liegt. Es hat sich nämlich gezeigt, dass diese Region der Bauelemente erfahrungsgemäß die am stärksten beanspruchten sind, weswegen eine Platzierung der Teststruktur in diesem Bereich vorteilhaft zuverlässig und rechtzeitig die Vorhersage eines Versagens von anderen Kontaktflächen ermöglicht. Außerdem wird hierdurch die Kontaktierung der Nutzschaltung auf Kontaktflächen verlagert, welche weniger beansprucht werden, was vorteilhaft die Lebensdauer der elektronischen Baugruppe verlängert.

Gemäß einer vorteilhaften Ausgestaltung des Bauelements ist vorgesehen, dass die Kontaktflächen, die elektrische Verbindungen zur elektrischen Nutzschaltung aufweisen, mit Kontaktstrukturen zur Kontaktierung auf einem Substrat versehen sind und die von der elektronischen Nutzschaltung unabhängige Kontaktfläche mit einer Teststruktur zur Kontaktierung auf dem Substrat und zur Feststellung eines drohenden Versagens der Kontaktstrukturen versehen ist. Hierbei handelt es sich um ein elektronisches Bauelement, welches bereits für die Montage auf einem Substrat konditioniert ist. Dies kann beispielsweise ein Flip-Chip oder ein BGA sein. Deratrige Bauelemente werden gewöhnlich vor der Montage mit Lotkugeln als Kontaktstrukturen versehen und mit diesen Lotkugeln auf das Substrat aufgesetzt. LGA werden vor der Montage mit Lotpaste bedruckt, wobei auf diesem Wege auch die Teststruktur gedruckt werden kann. In einem nachfolgenden Lötprozess werden dann sowohl die Kontaktstrukturen als auch die Teststruktur ausgebildet, indem die Lotkugeln oder die aus Lotpaste bestehenden Lotdepots aufgeschmolzen werden und auf diese Weise die Kontaktflächen des Bauelements mit den Kontakten des Substrats elektrisch verbunden werden. Hierdurch entsteht die eingangs beschriebene Baugruppe, wobei die mit dem Vorsehen der Teststruktur verbundenen Vorteile bereits eingehend erläutert wurden.

Gemäß einer anderen Ausgestaltung der Erfindung ist vorgesehen, dass die Teststruktur an eine im Bauelement befindliche Überwachungsschaltung angeschlossen ist. Diese Überwachungsschaltung kann ebenfalls elektrisch unabhängig von der elektronischen Nutzschaltung im Bauelement ausgeführt sein. Die Überwachungsschaltung kann beispielsweise Teil eines Überwachungsnetzwerks einer Maschine sein, in der die elektronische Baugruppe integriert ist. Eine andere Möglichkeit besteht darin, dass die Überwachungsschaltung in die Nutzschaltung des Bauelements integriert ist. Hierbei ist zu gewährleisten, dass ein Versagen der Teststruktur die Nutzfunktion des elektronischen Bauelements nicht beeinflusst. Im Falle eines Versagens der Teststruktur kann bei dieser Ausführung eine im Bauelement integrierte Diagnosefunktionalität genutzt werden, um erforderliche Wartungsmaßnahmen für die Baugruppe anzuzeigen.

Die Überwachungsschaltung kann auch eine Schnittstelle zur Ausgabe des Überwachungssignals aufweisen. In diesem Fall ist die Überwachungsschaltung selbst nicht für eine Auswertung des Überwachungssignals zuständig, sondern gibt dieses Überwachungssignal lediglich weiter. Die Schnittstelle kann vorteilhaft mit der elektronischen Nutzschaltung verbunden sein. Wie bereits erläutert, können auf diesem Wege Diagnosefunktionen genutzt werden, die in dem Bauelement verwirklicht sind.

Gemäß einer besonderen Ausgestaltung der Erfindung ist vorgesehen, dass in dem Bauelement zusätzlich eine Messvorrichtung für thermische und/oder mechanische Messgrößen vorgesehen ist. Durch Messvorrichtungen der genannten Art können vorteilhaft zusätzliche Aussagen über den Belastungszustand der Baugruppe gewonnen werden. Zum Beispiel kann eine thermische Überbeanspruchung dazu führen, dass ein Versagen der Teststruktur nicht mehr zuverlässig in einem genügend großen Zeitintervall vor dem Versagen der Kontaktstrukturen eintreten wird. In diesem Fall muss insbesondere bei sicherheitsrelevanten Baugruppen eine Wartungsmaßnahme eingeleitet werden, die eventuell zu einem vorzeitigen Austausch der Baugruppe oder des Bauelements führt. Als thermische Messvorrichtungen können beispielsweise Thermoelemente zum Einsatz kommen, deren elektrischer Widerstand sich temperaturabhängig ändert.

Die gleiche Konsequenz kann auch eine mechanische Überbeanspruchung haben, wobei diese indirekt durch eine thermische Überbeanspruchung (Wärmeausdehnung) oder durch eine mechanische Beanspruchung (z. B. durch Erschütterungen) ausgelöst werden kann. Als mechanische Messvorrichtungen können beispielsweise Dehnungsmessstreifen dienen, die auf dem piezoresistiven Effekt beruhen. Diese können auch rosettenartig angeordnet sein, um Dehnungen in mehreren Richtungen ermitteln zu können.

Die zusätzliche Messvorrichtung für thermische und/oder mechanische Messgrößen (es kann sich hierbei auch um zwei Messvorrichtungen handeln) kann an Kontaktflächen des Bauelements angeschlossen werden. Auch ist es möglich, dass die Messvorrichtung an eine Überwachungsschaltung angeschlossen ist, die in dem Bauelement realisiert ist. Zuletzt kann die zusätzliche Messvorrichtung auch direkt an die Nutzschaltung angeschlossen werden, wenn diese über Diagnosefunktionalitäten verfügt.

Außerdem wird die Aufgabe auch durch das eingangs angegebene Verfahren zur Überwachung mit einer in das Bauelement integrierten Überwachungsschaltung gelöst, indem für die mit der Teststruktur verknüpfte und mit der Messeinrichtung gemessene elektrische Größe ein Grenzwert festgelegt wird, der so gewählt ist, dass bei Erreichen dieses Grenzwertes die Funktion der Kontaktstruktur noch gewährleistet ist. Bei Erreichen des Grenzwertes wird mit der Auswertungseinheit dann ein dieses Ereignis anzeigendes Ausgangssignal generiert. Das Erreichen des Grenzwertes wird als Versagen der Teststruktur gewertet. Dabei muss es sich nicht um ein Komplettversagen, d. h. Unterbrechung des elektrischen Stromkreises, handeln, wie im Folgenden noch näher erläutert wird. Das Verfahren ist vorteilhaft geeignet, um die eingangs angegebene Baugruppe hinsichtlich eines drohenden Versagens der Nutzschaltung zu überwachen. Das generierte Ausgangssignal ist geeignet, um das drohende Versagen der Nutzschaltung anzuzeigen, so dass ggf. Wartungsmaßnahmen daraus abgeleitet werden können. Die Messeinrichtung und die Auswertungseinheit sind Teil der Überwachungs schaltung.

Das erfindungsgemäße Verfahren ist vorteilhaft ohne große Modifikationen für eine elektronische Baugruppe implementierbar. Wenn davon ausgegangen werden kann, dass die Teststruktur eindeutig vor den Kotaktstrukturen versagen wird, brauchen die Einflussfaktoren für die Lebensdauer der Baugruppe vorteilhaft nicht modelliert zu werden. Insbesondere kann die Heranziehung von Erfahrungswerten für eine Berechnung der Restlebensdauer unterbleiben. Die Annahme eines Versagensmodells ist nämlich mit Fehlern behaftet und deswegen nur begrenzt aussagefähig.

Demgegenüber ist die erfindungsgemäße Teststruktur derart ausgebildet, dass diese während des Betriebs der Baugruppe schneller geschädigt wird, als die Kontaktstrukturen. Verändern sich die Betriebsbedingungen der elektronischen Baugruppe, so verändern sich entsprechend auch die Betriebsbedingungen der Teststruktur, und müssen daher nicht in ein Rechenmodell einbezogen werden.

Eine vorteilhaft besonders einfache Ausführungsform der Erfindung wird erhalten, wenn die elektrische Größe hinsichtlich des Vorhandenseins einer elektrischen Verbindung durch die Teststruktur ausgewertet wird und der Grenzwert als Extremwert der elektrischen Größe festgelegt wird. Das Versagen der Teststruktur ist damit der komplette Verlust eines elektrischen Kontakts zwischen der betreffenden Kontaktfläche am Bauelement und dem Kontakt auf dem Substrat. Als Extremwert ist damit die unter diesen Bedingungen gemessene elektrische Größe zu verstehen. Wird der Strom an der Teststruktur gemessen, so ist der zugehörige Extremwert Null. Wird die an der Teststruktur anliegende Spannung gemessen, so kann der Extremwert beispielsweise der Nennspannung entsprechen, wenn diese bei einem Kontaktverlust an der Teststruktur nicht mehr abfällt.

Eine andere vorteilhafte Möglichkeit liegt darin, dass als elektrische Größe der elektrische Widerstand der Teststruktur überwacht wird und der zugehörige Grenzwert für einen zulässigen Maximalwert des elektrischen Widerstands festgelegt wird. Mit diesem Messverfahren kann eine Rissbildung in der Teststruktur verfolgt werden, weil der Widerstand bei fortschreitender Rissbildung steigt. Vorteilhaft kann bei bekannter Spannung eine Strommessung erfolgen, wobei der gemessene Strom als Maß für den Widerstand herangezogen wird. Dieses Verfahren kann auch mit dem vorstehend beschriebenen kombiniert werden. Denn spätestens bei einer kompletten Dekontaktierung der Teststruktur fällt der gemessene Strom auf Null ab. Eine vorhergehende Abnahme des gemessenen Stroms kann jedoch auf das drohende Ereignis eines Komplettversagens der Teststruktur hinweisen, wodurch vorteilhaft erweiterte Aussagen hinsichtlich einer zu erwartenden Restlebensdauer möglich werden, ohne hierfür zusätzliche Messungen durchführen zu müssen.

Der Maximalwert, der als Grenzwert definiert wird, kann vorteilhaft als Vielfaches oder Teil eines gemessenen Anfangswerts der elektrischen Größe bei Inbetriebnahme der elektronischen Baugruppe festgelegt werden. Bei der Überwachung des elektrischen Widerstandes beträgt der Maximalwert beispielsweise ein Vielfaches > 1. Dies hat den Vorteil, dass fertigungsbedingte Ungenauigkeiten hinsichtlich des elektrischen Verhaltens der Teststruktur Berücksichtigung finden können. Abhängig von dem elektrischen Widerstand der Teststruktur wird sich bei Inbetriebnahme der elektronischen Baugruppe ein bestimmter Wert der elektrischen Größe (z. B. gemessene Stromstärke) einstellen. Der Strom wird dann im Falle des Betriebs der elektronischen Baugruppe absinken, was bedeutet, dass der elektrische Widerstand ansteigt. Dabei ist lediglich ein Anstieg um einen bestimmten Faktor, der größer als 1 ist, erlaubt, wobei dieser Faktor durch den Maximalwert festgelegt wird. Zusätzlich kann, wie bereits erläutert, eine mechanische und/oder thermische Größe gemessen werden, die ebenfalls durch die Auswertungseinheit verarbeitet wird. Diese Größe ermöglicht zusätzliche Aussagen über den Zustand der elektronischen Baugruppe, wodurch zusätzliche Kriterien für eine erforderliche Wartung oder den Austausch von Baugruppe oder Bauelement erzeugt werden.

Weitere Einzelheiten der Erfindung werden nachfolgend anhand der Zeichnung beschrieben. Gleiche oder sich entsprechende Zeichnungselemente werden jeweils durch die gleichen Bezugszeichen bezeichnet und werden nur insoweit mehrfach erläutert, wie sich Unterschiede zwischen den einzelnen Figuren ergeben. Es zeigen:
- Figur 1 und 2: ein Ausführungsbeispiel für das erfindungsgemäße elektronische Bauelement, ausgeführt als BGA, als Aufsicht auf die Montageseite,
- Figur 3: ein weiteres Ausführungsbeispiel des erfindungsgemäßen Bauelements, welches mit zwei Reihen von Kontaktdrähten versehen ist, als Aufsicht,
- Figur 4: ein weiteres Ausführungsbeispiel des erfindungsgemäßen Bauelements in Form eines LGAs als Aufsicht,
- Figur 5: ein Ausführungsbeispiel der erfindungsgemäßen Bauelements gemäß Figur 1 im montierten Zustand als schematischer Querschnitts dargestellt und
- Figur 6 und 7: mögliche Verläufe des Messsignals (Stromstärke I) in Abhängigkeit von der Betriebszeit t gemäß zwei Ausführungsbeispielen des erfindungsgemäßen Verfahrens.

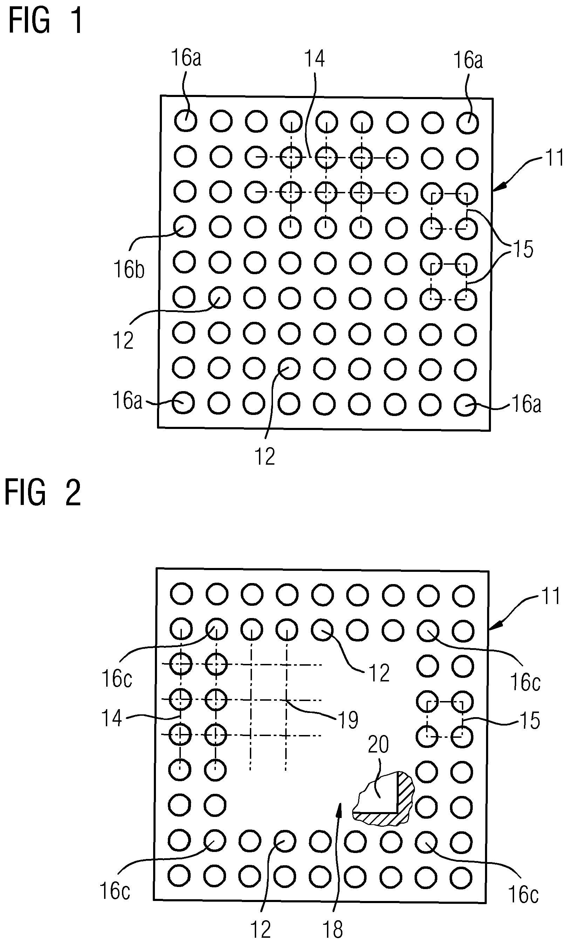

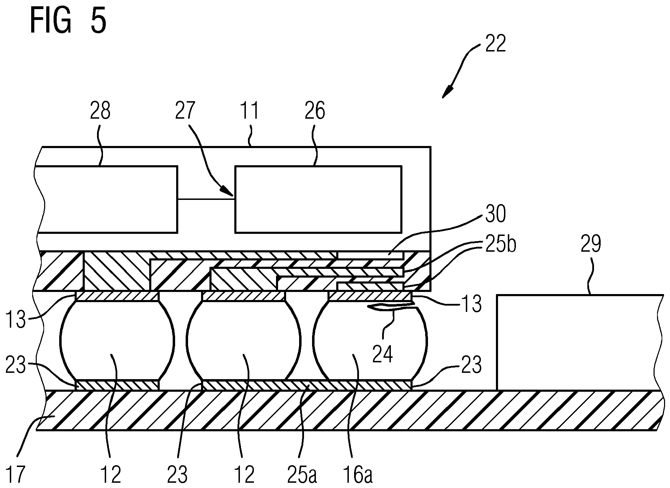

In Figur 1 ist ein BGA als Bauelement 11 dargestellt. Dieses besitzt in an sich bekannter Weise eine Vielzahl von Kontaktstrukturen 12, welche in Form von Lotkugeln auf nicht näher dargestellten Kontaktflächen (vgl. 13 in Figur 5) aufgebracht sind. Unter jeder der Kontaktstrukturen 12 befindet sich somit eine solche Kontaktfläche 13.

Die Kontaktflächen mit den darauf befindlichen Kontaktstrukturen 12 sind in einem 9x9 Array angeordnet. Somit ergeben die Kontaktstrukturen und die darunter befindlichen Kontaktflächen ein Raster 14, wobei dieses Raster gemäß Figur 1 durch quadratische Rasterzellen 15 definiert ist. Jeweils auf den vier Ecken der quadratischen Rasterzelle liegen somit die Kontaktflächen und die Kontaktstrukturen 12. Von den Rasterzellen 15 sind in Figur 1 nur zwei exemplarisch dargestellt. Diese werden durch eine strichpunktierte Linie angedeutet.

Außer den Kontaktstrukturen 12 sind an den vier Ecken des Bauelements 11 Teststrukturen 16a vorgesehen. Auch unter den Teststrukturen 16a befinden sich Kontaktflächen 13 (vgl. Figur 5). Bei dem BGA gemäß Figur 1 sind nach Kontaktierung der Teststrukturen 16a und der Kontaktstrukturen 12 (alle nicht mit Bezugszeichen versehenen Lotkugeln gemäß Figur 1 sind Kontaktstrukturen) mit einem nicht dargestellten Substrat (vergleiche Figur 5) die jeweiligen Eckplätze des Rasters die mechanisch am stärksten beanspruchten Verbindungen zwischen Bauelement und Substrat. Daher werden auf den dazugehörigen Kontaktflächen die Teststrukturen 16a vorgesehen, da diese bei einem fortschreitenden Betrieb der Baugruppe (bestehend aus dem Bauelement 11 und einem Substrat 17: vgl. Figur 5) als erste in ihrer Funktion einer Leitung des elektrischen Stroms versagen werden.

In Abhängigkeit der mechanischen Eigenschaften des Substrats und des Aufbaus des Bauelements 11 kann es auch dazu kommen, dass andere durch die Lotkugeln gebildete Kontaktierungen am stärksten belastet sind. Dies lässt sich beispielsweise durch Finite-Elemente-Methoden berechnen oder durch Versuche ermitteln. In einem solchen Fall müssen die entsprechenden Lotkugeln an der Stelle der stärksten mechanischen Belastung als Teststrukturen 16b ausgeführt werden, was exemplarisch in Figur 1 dargestellt ist.

Diejenigen Lotkugeln, welche als Teststrukturen zum Einsatz kommen sollen, dürfen bei der Auslegung der durch das Bauelement 11 realisierten Nutzschaltung nicht als an dieser beteiligte Kontakte berücksichtigt werden, damit die Nutzschaltung elektrisch unabhängig von den Teststrukturen betrieben werden kann.

In Figur 2 ist ein BGA als Bauelement 11 dargestellt, bei dem nicht alle möglichen Plätze des Rasters 14 belegt sind. Vielmehr sind die Kontaktstrukturen 12 in zwei Reihen jeweils parallel zur Kante des BGAs rahmenartig um einen freien Mittelbereich 18 angeordnet, so dass freie Rasterplätze 19 (Eckpunkte der jeweiligen dort befindlichen Rasterzellen 15) zu erkennen sind. Im Mittelbereich 18 ist, wie in dem teilweise aufgeschnittenen Bereich zu erkennen ist, ein Halbleiterbaustein 20 in den BGA eingebettet. Aufgrund dieser Tatsache liegen in unmittelbarer Nähe der Ecken dieses Halbleiterbausteins 20 die am stärksten beanspruchten Stellen für eine Kontaktierung mittels der Lotkugeln. Daher werden die diagonal am nächsten gelegenen Lotkugeln als Teststrukturen 16c verwendet. An jeder der vier Ecken des eingebetteten Halbleiterbausteins 20 ist eine solche Teststruktur 16c vorgesehen. Die restlichen Lotkugeln werden zur Bildung von Kontaktstrukturen 12 genutzt (alle nicht mit Bezugszeichen versehenen Lotkugeln gemäß Figur 1 sind Kontaktstrukturen).

Die in Figur 1 und Figur 2 dargestellten Konfigurationen von Lotkugeln können auch auf der Unterseite von Flip-Chips verwendet werden. Daher gelten die vorstehend für BGAs getroffenen Aussagen (bis auf diejenigen zu einem eingebetteten Halbleiterbaustein) für Flip-Chips als Bauelemente analog.

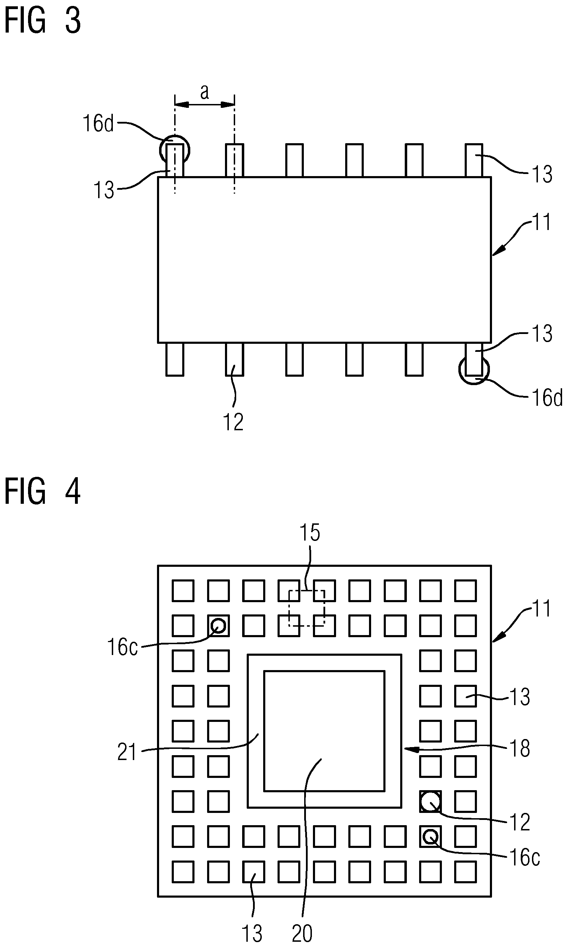

In Figur 3 ist ein Bauelement 11 dargestellt, welches seitlich Kontaktstrukturen aufweist, die in gleichmäßigen Abständen a an den langen Seiten des Bauelements angeordnet sind und für eine Durchsteckmontage des Bauelements 11 auf einem nicht dargestellten Substrat geeignet sind. Auch hier werden die diagonal gegenüberliegenden beiden äußeren Kontaktflächen 13 im weiteren Verlauf der Montage für die Herstellung von Teststrukturen 16d genutzt. Diese sind in Figur 3 angedeutet als Lötverbindungen einer Durchsteckmontage des nicht näher dargestellten Substrats, um die Lage der Teststrukturen 16d in Figur 3 zu verdeutlichen. Die restlichen Kontaktflächen 13 stehen zur Herstellung nicht näher dargestellter Kontaktstrukturen zur Verfügung. Statt Kontaktstrukturen für eine Durchsteckmontage können auch Kontaktstrukturen für eine SMD-Montage zum Einsatz kommen (in Figur 3 nicht dargestellt). Diese weisen dann Kontaktflächen an den Kontaktstrukturen auf, mit denen das Bauelement 11 auf Kontaktpads des Substrates aufgesetzt werden kann.

In Figur 4 ist die Unterseite eines LGAs als Bauelement 11 dargestellt. Dieser weist eine Vielzahl von Kontaktflächen 13 auf, die in einer zu Figur 2 vergleichbaren Konfiguration in zwei Reihen parallel zur Kante des LGAs angeordnet sind. Hierbei liegen die Kontaktflächen wieder auf einen Raster, wobei lediglich eine der Rasterzellen 15 exemplarisch dargestellt ist.

Im Mittelbereich 18 befindet sich eine Metallisierung 21 aus Kupfer. Diese dient einer Wärmeabfuhr aus einem Halbleiterbaustein 20, der dort montiert ist. Der montierte Halbleiterbaustein 20 bewirkt eine ähnliche Verteilung der mechanischen Belastungsspitzen wie zu Figur 2 erläutert. Daher wurden zwei der Kontaktflächen 13 ausgewählt, die sich diagonal gegenüberliegen und diagonal den beiden Ecken des Halbleiterbaustein 20 am nächsten liegen. Um diese zu kennzeichnen, sind dort Teststrukturen 16c in Figur 4 dargestellt. Die restlichen Kontaktflächen 13 stehen zur Ausbildung von Kontaktstrukturen 12 in Form von Lotdepots zur Verfügung, wobei in Figur 4 nur eine von ihnen dargestellt ist.

In Figur 4 ist zu erkennen, dass die Teststrukturen 16c ein geringeres Volumen aufweisen, als die Kontaktstrukturen 12. Hierdurch wird erreicht, dass die Belastungen in den Teststrukturen 16c während des Betriebs erhöht werden und diese daher zu einem früheren Zeitpunkt versagen. Diese Maßnahme dient dazu, die Sicherheitsreserve bis zum Eintritt eines Versagens der Kontaktstrukturen 12 zu vergrößern. Bei der Montage des Bauelementes 11 muss dabei sichergestellt werden, dass die zuverlässige Ausbildung eines Kontaktes auch bei den volumenmäßig kleineren Teststrukturen erfolgen kann, beispielsweise durch erhöhte Kontakte auf dem Substrat oder durch eine modifizierte Geometrie der Teststrukturen mit einer Höhe, die derjenigen der Kontaktstrukturen trotz geringeren Volumens entspricht.

In Figur 5 ist eine Baugruppe 22 zu erkennen, die das Bauelement 11, montiert auf einem Substrat 17 aufweist. Das Substrat 17 stellt hierzu Kontakte 23 zur Verfügung, die über die Kontaktstrukturen 12 mit den Kontaktflächen 13 des Bauelements 11 verbunden sind.

An der Ecke des Bauelements 11 ist entsprechend der Darstellung in Figur 1 die Teststruktur 16a vorgesehen. Da die Teststruktur 16a im Betrieb der Baugruppe 22 mechanisch stärker belastet wird, als die Kontaktstruktur 12, ist zu erkennen, dass sich in der Teststruktur 16a bereits ein Riss 24 gebildet hat. Um den Rissfortschritt in der Teststruktur 16a überwachen zu können, ist der Kontakt 23 der Teststruktur 16 mit dem Kontakt 23 der benachbarten Kontaktstruktur 12 über einen elektrischen Leitpfad 25a verbunden. Über die besagte Kontaktstruktur 12 und die Teststruktur 16a lässt sich damit ein Stromkreis erzeugen, der über Leitpfade 25b im Bauelement 11 zu einer in Figur 5 nur angedeuteten Messeinrichtung 26 zur Erzeugung eines geeigneten Messsignals geführt werden. Diese bildet gemäß Figur 5 einen selbständigen Baustein. Die Messeinrichtung 26 kann aber auch in den die Nutzschaltung 28 enthaltenden Baustein baulich intergiert sein (nicht dargestellt) .

Alternativ zu der Kontaktierung der Teststruktur 23 mit einer der Kontaktstrukturen 12, wie in Figur 5 dargestellt, können die Teststrukturen 16a gemäß Figur 1 auch in einem Überwachungsstromkreis in Reihe geschaltet werden. Hierbei werden in einer in Figur 5 nicht dargestellten Weise die Kontakte 23 der Teststrukturen 16a durch Leitpfade (wie 25a) auf dem Substrat bzw. die Kontaktflächen 13 der Teststrukturen 16a durch Leitpfade (wie 25b) im Bauelement 11 derart miteinander verbunden, dass eine Reihenschaltung der Teststrukturen 16a entsteht. Bereits der Ausfall der ersten Teststruktur 16a kann auf diesem Wege auf einfache Weise detektiert werden.

Die Messeinrichtung 26 weist eine Schnittstelle 27 für die Ausgabe eines Überwachungssignals auf. Gemäß Figur 5 ist diese Schnittstelle mit einer Nutzschaltung 28 verbunden, wobei diese eine nicht näher dargestellte Diagnosefunktion aufweist, welche zur Ausgabe der Notwendigkeit einer Wartung der Baugruppe 22 genutzt werden kann. Bei dieser Ausführungsform übernimmt die Diagnosefunktion die Aufgabe einer Auswertungseinheit für das Überwachungssignal.

Alternativ hierzu (allerdings in Figur 5 nicht dargestellt) kann die Schnittstelle 27 auch mit einer Sendeeinheit im Bauelement 11 verbunden werden, um drahtlos ein Überwachungssignal an eine externe Überwachungseinheit abzugeben. Eine externe Auswertungseinheit 29 ist mit dem Substrat 17 kontaktiert.

In Figur 5 ist eine weitere Messeinrichtung 30 zu erkennen, bei der es sich um ein Thermoelement oder einen piezoresistiven Dehnungssensor, beispielsweise in Form einer Stessrosette (rosettenartig angeordnete Dehnungselemente zur Feststellung von Spannungen / Dehnungen in mehreren Richtungen) handeln kann.

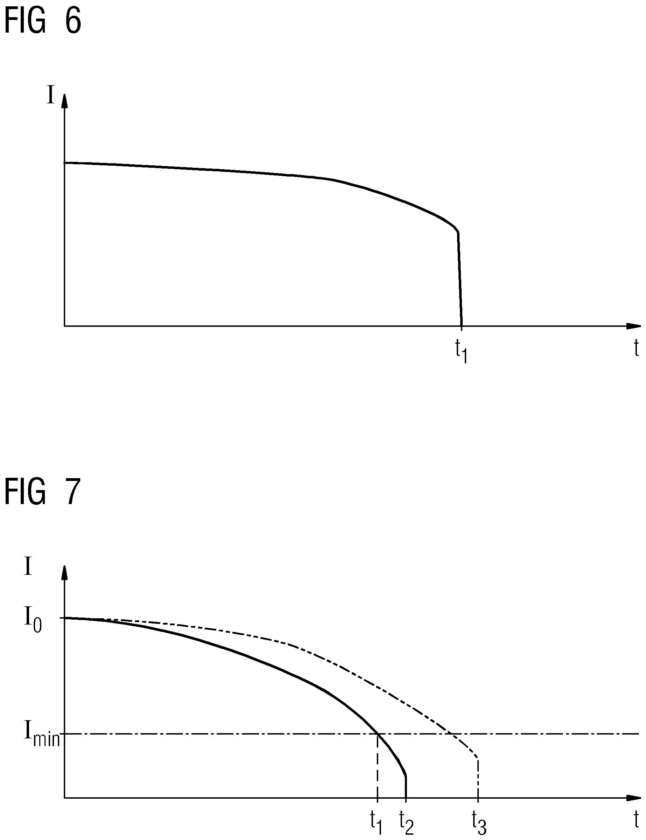

In Figur 6 ist die einfachste Form einer Überwachung der elektronischen Baugruppe hinsichtlich eines drohenden Versagens der Nutzschaltung dargestellt. Es wird ein Strom I gemessen, der über eine oder mehrere der Teststrukturen fließt. Versagt die Teststruktur in dem Sinne, dass ein Stromfluss aufgrund eines Bruchs der Teststruktur nicht mehr übertragbar ist, so sinkt der Strom zu diesem Zeitpunkt t₁ auf 0. Zu diesem Zeitpunkt sind die anderen Kontaktstrukturen noch intakt, weswegen es bis zu diesem Zeitpunkt noch nicht zu einem Ausfall der Nutzschaltung des Bauelements gekommen ist. Das Ereignis, dass eine der Teststrukturen versagt hat, löst dann ein Signal mit dem Inhalt aus, dass eine Wartung der elektronischen Baugruppe erforderlich ist.

In Figur 7 wird nicht nur das Vorhandensein eines Stroms I, sondern auch dessen Höhe durch die Auswertungseinheit aufgezeichnet. Es wird ein Strom I₀ ermittelt, der über die untersuchte Teststruktur zum Zeitpunkt der Inbetriebnahme der elektronischen Baugruppe fließt. Anschließend wird ein Grenzwert für den Strom Iₘᵢₙ festgelegt, der mindestens über die Teststruktur fließen muss, damit diese als intakt bewertet wird. Dieser Grenzwert wird nach einer Betriebsdauer t₁ erreicht. Figur 7 ist zu entnehmen, dass dieses Verfahren im Vergleich zu dem Verfahren gemäß Figur 6 zu einem früheren Versagen der Teststruktur führt (Das Verfahren gemäß Figur 6 würde zum Zeitpunkt t2 ansprechen). Das Verfahren gemäß Figur 7 wird dann gewählt, wenn der zeitliche Abstand zum voraussichtlichen Versagen einer Kontaktstruktur zum Zeitpunkt t3 keine genügende Sicherheit bieten würde. Das Erreichen des definierten Grenzwerts für den Strom Iₘᵢₙ vergrößert somit die Sicherheit gegenüber dem nicht gewünschten Ereignis, dass eine Kontaktstruktur vor der Teststruktur versagt.

## Patentansprüche

1. Elektronisches Bauelement,
• wobei das Bauelement (11) über auf einem regelmäßigen Raster (14) oder über in gleichmäßigen Abständen angeordnete Kontaktflächen (13) für Kontaktstrukturen (12) zur Kontaktierung auf einem Substrat (17) verfügt,
• wobei elektrische Verbindungen zwischen einer mit dem Bauelement realisierten elektronischen Nutzschaltung (28) und den Kontaktflächen (13) ausgebildet sind,
• wobei eine der Kontaktflächen (13) elektrisch unabhängig von der elektronischen Nutzschaltung (28) und an eine im Bauelement befindliche Überwachungsschaltung angeschlossen ist und mit einer anderen von der elektronischen Nutzschaltung (28) elektrisch unabhängigen Kontaktfläche (13) oder mit einem Masseanschluss elektrisch verbunden ist,
• wobei die Kontaktflächen (13), die elektrische Verbindungen zur elektronischen Nutzschaltung (28) aufweisen, mit Kontaktstrukturen (12) zur Kontaktierung auf einem Substrat (17) versehen sind und
• wobei die von der elektronischen Nutzschaltung unabhängige Kontaktfläche (13) mit einer Teststruktur (16a, 16b, 16c, 16d) zur Kontaktierung auf dem Substrat und zur Feststellung eines drohenden Versagens der Kontaktstrukturen (12) versehen ist,
und wobei
die Teststruktur (16a, 16b, 16c, 16d) im Vergleich zu den Kontaktstrukturen (12) einen geringeren Widerstand gegen ein Versagen bei den im Betrieb der Baugruppe auftretenden Belastungen aufweist.

2. Bauelement nach Anspruch 1, wobei die Überwachungsschaltung eine Schnittstelle (27) zur Ausgabe eines Überwachungssignals aufweist.

3. Bauelement nach Anspruch 2, wobei die Schnittstelle (27) mit der elektronischen Nutzschaltung verbunden ist.

4. Bauelement nach einem der Ansprüche 1 bis 3,
wobei in dem Bauelement zusätzlich ein Messelement für thermische und/oder mechanische Messgrößen vorgesehen ist.

5. Bauelement nach Anspruch 1 bis 4, wobei die Teststruktur (16a, 16b, 16c, 16d) auf einer Kontaktfläche (13) kontaktiert ist, die im Betrieb der Baugruppe höheren Belastungen ausgesetzt ist, als andere mit Kontaktstrukturen (12) kontaktierte Kontaktflächen (13).

6. Bauelement nach Anspruch 1 bis 5, wobei das Bauelement (11) ein Ball Grid Array oder Land Grid Array ist und die Teststruktur (16a, 16b, 16c) auf einer Kontaktfläche vorgesehen ist, die einer Ecke des Ball Grid Arrays oder Land Grid Arrays oder der Ecke eines in den Ball Grid Array eingebetteten oder auf das Land Grid Arrays aufgesetzten Halbleiterbausteins (20) am nächsten liegt.

7. Verfahren zu Überwachung einer aus Kontaktstrukturen (12) bestehenden elektrischen Kontaktierung eines elektronischen Bauelementes (11) mit einem Substrat (17), wobei
• das Bauelement (11) über auf einem regelmäßigen Raster (14) oder über in gleichmäßigen Abständen angeordnete Kontaktflächen (13) zur Kontaktierung der Kontaktstrukturen (12) verfügt,
• zusätzlich zu den Kontaktstrukturen (12) zwischen dem Bauelement (11) und dem Substrat (17) mindestens eine Teststruktur (16a, 16b, 16c, 16d) ausgebildet ist,
• die Teststruktur (16a, 16b, 16c, 16d) auf einer von den Kontaktstrukturen (12) ungenutzten Kontaktfläche (13) kontaktiert ist,
• mit einer Messeinrichtung (26) eine mit der Teststruktur (16a, 16b, 16c, 16d) verknüpfte elektrische Größe gemessen wird und
• die elektrische Größe mit einer Auswertungseinheit hinsichtlich einer Funktionszuverlässigkeit der elektrischen Kontaktierung ausgewertet wird,
• für die gemessene elektrische Größe ein Grenzwert festgelegt wird, der so gewählt wird, dass bei Erreichen dieses Grenzwertes die Funktion der Kontaktstrukturen (12) noch gewährleistet ist und
• bei Erreichen des Grenzwertes mit der Auswertungseinheit ein dieses Ereignis anzeigendes Ausgangssignal generiert wird,
• die Messeinrichtung (26) und die Auswertungseinheit in dem Bauelement (11) eine Überwachungsschaltung bilden, die in das Bauelement (11) integriert ist, und wobei die Teststruktur (16a, 16b, 16c, 16d) im Vergleich zu den Kontaktstrukturen (12) mit einem geringeren Widerstand gegen ein Versagen bei den im Betrieb der Baugruppe auftretenden Belastungen hergestellt wird.

8. Verfahren nach Anspruch 7, wobei die elektrische Größe hinsichtlich des Vorhandenseins einer elektrischen Verbindung durch die Teststruktur (16a, 16b, 16c, 16d) ausgewertet wird und der Grenzwert als Extremwert der elektrischen Größe festgelegt wird.

9. Verfahren nach einem der Ansprüche 7 oder 8, wobei als elektrische Größe der elektrische Widerstand der Teststruktur überwacht wird und der zugehörige Grenzwert für einen zulässigen Maximalwert des elektrischen Widerstandes festgelegt wird.

10. Verfahren nach Anspruch 9, wobei der Maximalwert als Vielfaches eines gemessenen Anfangswertes des elektrischen Widerstands bei Inbetriebnahme der elektronischen Baugruppe festgelegt wird.

11. Verfahren nach einem der Ansprüche 7 bis 10, wobei zusätzlich zur elektrischen Größe eine mechanische und/oder thermische Größe gemessen und durch die Auswertungseinheit verarbeitet wird.

## Claims

1. Electronic component,
• wherein the component (11) has contact areas (13), which are arranged on a regular grid (14) or at uniform distances, for contact structures (12) for contact-connection on a substrate (17),
• wherein electrical connections are formed between an electronic useful circuit (28), which is realized by way of the component, and the contact areas (13),
• wherein one of the contact areas (13) is electrically independent of the electronic useful circuit (28) and is connected to a monitoring circuit which is located in the component and is electrically connected to another contact area (13), which is electrically independent of the electronic useful circuit (28), or to an earth connection,
• wherein the contact areas (13) which have electrical connections to the electronic useful circuit (28) are provided with contact structures (12) for contact-connection on a substrate (17), and
• wherein the contact area (13) which is independent of the electronic useful circuit is provided with a test structure (16a, 16b, 16c, 16d) for contact-connection on the substrate and for determining the threat of failure of the contact structures (12), and wherein
the test structure (16a, 16b, 16c, 16d) has a lower resistance to failure in comparison to the contact structures (12) under the loads which occur during operation of the assembly.

2. Component according to Claim 1, wherein the monitoring circuit has an interface (27) for outputting a monitoring signal.

3. Component according to Claim 2, wherein the interface (27) is connected to the electronic useful circuit.

4. Component according to one of Claims 1 to 3, wherein a measuring element for thermal and/or mechanical measurement variables is additionally provided in the component.

5. Component according to Claims 1 to 4, wherein the test structure (16a, 16b, 16c, 16d) is contact-connected on a contact area (13) which, during operation of the assembly, is subject to higher loads than other contact areas (13) which are contact-connected to contact structures (12).

6. Component according to Claims 1 to 5, wherein the component (11) is a ball grid array or land grid array, and the test structure (16a, 16b, 16c) is provided on a contact area which is situated closest to a corner of the ball grid array or land grid array or to the corner of a semiconductor module (20) which is embedded into the ball grid array or placed onto the land grid array.

7. Method for monitoring an electrical contact-connection, which comprises contact structures (12), of an electronic component (11) with a substrate (17), wherein
• the component (11) has contact areas (13), which are arranged on a regular grid (14) or at uniform distances, for contact-connection of the contact structures (12),
• at least one test structure (16a, 16b, 16c, 16d) is formed between the component (11) and the substrate (17) in addition to the contact structures (12),
• the test structure (16a, 16b, 16c, 16d) is contact-connected on a contact area (13) which is not used by the contact structures (12),
• an electrical variable which is linked to the test structure (16a, 16b, 16c, 16d) is measured using a measuring device (26), and
• the electrical variable is evaluated in respect of a degree of functional reliability of the electrical contact-connection using an evaluation unit,
• a limit value is defined for the measured electrical variable, the said limit value being selected such that functioning of the contact structures (12) is still ensured when the said limit value is reached, and,
• when the limit value is reached, an output signal which indicates this event is generated using the evaluation unit,
• the measuring device (26) and the evaluation unit form a monitoring circuit in the component (11), which monitoring circuit is integrated into the component (11),
and wherein the test structure (16a, 16b, 16c, 16d) is produced with a lower resistance to failure in comparison to the contact structures (12) under the loads which occur during operation of the assembly.

8. Method according to Claim 7, wherein the electrical variable is evaluated by the test structure (16a, 16b, 16c, 16d) in respect of the presence of an electrical connection, and the limit value is defined as an extreme value of the electrical variable.

9. Method according to either of Claims 7 and 8, wherein the electrical resistance of the test structure is monitored as electrical variable, and the associated limit value is defined for an admissible maximum value of the electrical resistance.

10. Method according to Claim 9, wherein the maximum value is defined as a multiple of a measured starting value of the electrical resistance when the electronic assembly is started up.

11. Method according to one of Claims 7 to 10, wherein a mechanical and/or thermal variable is measured and processed by the evaluation unit in addition to the electrical variable.

## Revendications

1. Composant électronique,
• dans lequel le composant (11) dispose, pour la mise en contact sur un substrat (17), de surfaces (13) de contact, disposées sur une trame (14) régulière ou à des distances uniformes, pour des structures (12) de contact,
• dans lequel les liaisons électriques sont constituées entre les surfaces (13) de contact et un circuit (28) électronique utile réalisé par le composant,
• dans lequel l'une des surfaces (13) de contact est connectée, indépendamment électriquement, du circuit (28) électronique utile et a un circuit de contrôle se trouvant dans le composant et est reliée électriquement à une borne de masse ou à une autre surface (13) de contact indépendante électriquement du circuit (28) électronique utile,
• dans lequel les surfaces (13) de contact, qui ont des liaisons électriques avec le circuit (28) électronique utile, sont pourvues de structures (12) de contact pour la mise en contact sur un substrat (17) et
• dans lequel la surface (13) de contact indépendante du circuit électronique utile est pourvue d'une structure (16a, 16b, 16c, 16d) de test pour la mise en contact sur le substrat et pour la constatation d'une menace de défaillance des structures (12) de contact,
et dans lequel la structure (16a, 16b, 16c, 16d) de test a, par rapport aux structures (12) de contact, une résistance plus petite à la défaillance aux contraintes se produisant en fonctionnement du composant.

2. Composant suivant la revendication 1,
dans lequel le circuit de contrôle a une interface (27) d'émission d'un signal de contrôle.

3. Composant suivant la revendication 2,
dans lequel l'interface (27) est reliée au circuit électronique utile.

4. Composant suivant l'une des revendications 1 à 3,
dans lequel il est prévu, dans le composant, supplémentairement, un élément de mesure de grandeurs de mesure thermiques ou mécaniques.

5. Composant suivant l'une des revendications 1 à 4,
dans lequel la structure (16a, 16b, 16c, 16d) de test est mise en contact sur une surface (13) de contact, qui, lorsque le composant est en fonctionnement, est soumise à des contraintes plus grandes que d'autres surfaces (13) de contact mises en contact avec des structures (12) de contact.

6. Composant suivant l'une des revendications 1 à 5,
dans lequel le composant (11) est un ball grid array ou un land grid array et la structure (16a, 16b, 16c, 16d) de test est prévue sur une surface de contact, qui est la plus proche d'un coin du ball grid array ou du land grid array ou du coin d'un module (20) à semi-conducteur incorporé dans le ball grid array ou mis sur le land grid array.

7. Procédé de contrôle d'une mise en contact électrique constitué de structures (12) de contact d'un composant (11) électronique avec un substrat (17), dans lequel
• le composant (11) dispose, pour la mise en contact des structures (12) de contact, de surfaces (13) de contact disposées sur une trame (14) régulière ou à des distances uniformes;
• en plus des structures (12) de contact, au moins une structure (16a, 16b, 16c, 16d) de test est constituée entre le composant (11) et le substrat (17),
• la structure (16a, 16b, 16c, 16d) de test est mise en contact sur une surface (13) de contact inutilisée par les structures (12) de contact,
• on mesure, par un dispositif (26) de mesure, une grandeur électrique reliée à la structure (16a, 16b, 16c, 16d) de test,
• on exploite la grandeur électrique par une unité d'exploitation en ce qui concerne une fiabilité de fonctionnement de la mise en contact électrique,
• on fixe, pour la grandeur électrique mesurée, une valeur limite, choisie de manière à ce que, lorsque cette valeur limite est atteinte, le fonctionnement des structures (12) de contact soient encore assurées et
• lorsque la valeur limite est atteinte, on produit, par l'unité d'exploitation, un signal de sortie indiquant cet événement,
• le dispositif (26) de mesure et l'unité d'exploitation forment, dans le composant (11), un circuit de contrôle, qui est intégré dans le composant (11),
et dans lequel on produit la structure (16a, 16b, 16c, 16d) de test en lui donnant, aux contraintes se produisant lorsque le composant fonctionne, une résistance à la défaillance plus petite que celle des structures (12) de contact.

8. Procédé suivant la revendication 7,
dans lequel on exploite la grandeur électrique en ce qui concerne la présence d'une liaison électrique dans la structure (16a, 16b, 16c, 16d) de test et on fixe la valeur limite comme étant une valeur extrême de la grandeur électrique.

9. Procédé suivant l'une des revendications 7 ou 8,
dans lequel on contrôle la valeur de la résistance électrique de la structure de test et on fixe la valeur limite associée à une valeur maximum admissible de la résistance électrique.

10. Procédé suivant la revendication 9,
dans lequel on fixe la valeur maximum à un multiple d'une valeur initiale mesurée de la résistance électrique lors de la mise en fonctionnement du composant électronique.

11. Procédé suivant l'une des revendications 7 à 10,
dans lequel on mesure, supplémentairement à la grandeur électrique, une grandeur mécanique et/ou thermique et on la traite par l'unité d'exploitation.
